# FASCICULE DE BREVET EUROPEEN

(11) **EP 2 334 443 B1**
(45) Date de publication et mention de la délivrance du brevet: **26.10.2016**
(21) Numéro de dépôt: 09784258.7
(22) Date de dépôt: 09.07.2009
(51) Int. Cl.: B05D 7/14, B82Y 30/00, C10M 103/00, C23C 14/08, C23C 28/04, C23C 16/56, C23C 28/00, C23C 14/28, B05D 5/08, B82Y 40/00

(54) **PROCÉDÉ D'UTILISATION D'UNE COUCHE MINCE SUPRAGLISSANTE CARACTÉRISÉE PAR SON PROCEDE D'OBTENTION.**
VERFAHREN ZUR VERWENDUNG EINER SUPERGLATTEN DÜNNEN SCHICHT, GEKENNZEICHNET DURCH DAS HERSTELLUNGSVERFAHREN DAFÜR
METHOD FOR USING A SUPER-SLIPPERY THIN LAYER CHARACTERISED BY THE METHOD FOR MAKING SAME

(30) Priorité: 01.08.2008 FR 0804403
(43) Date de publication de la demande: 22.06.2011
(73) Titulaire: Commissariat à l'Énergie Atomique et aux Énergies Alternatives, 75015 Paris (FR)
(72) Inventeur: DUCROS, Cédric, F-38690 Bevenais (FR); GAVILLET, Jérôme, FR - 38120 SAINT-EGREVE (FR)
(74) Mandataire: Gevers & Orès
(86) Numéro de dépôt international: PCT/FR2009/000850
(87) Numéro de publication internationale: WO 2010/012879

(56) Documents cités:
- JP-A- 2003 226 977
- US-A1- 2008 145 528
- TADANAGA K ET AL: "Formation process of super-water-repellent Al2O3 coating films with with transparency by the sol-gel method" JOURNAL OF THE AMERICAN CERAMIC SOCIETY AMERICAN CERAMIC SOC USA, vol. 80, no. 12, décembre 1997 (1997-12), pages 3213-3216, XP002507032 ISSN: 0002-7820
- MA ET AL: "Superhydrophobic surfaces" CURRENT OPINION IN COLLOID AND INTERFACE SCIENCE, LONDON, GB, vol. 11, no. 4, 15 novembre 2006 (2006-11-15), pages 193-202, XP005765742 ISSN: 1359-0294
- LINGBO ZHU ET AL: "Optimizing Geometrical Design of Superhydrophobic Surfaces for Prevention of Microelectromechanical System (MEMS) Stiction" ELECTRONIC COMPONENTS AND TECHNOLOGY CONFERENCE 2006, 56TH SAN DIEGO, CA MAY 30 - JUNE 2, 2006, PISCATAWAY, NJ, USA,IEEE, 30 mai 2006 (2006-05-30), pages 1129-1135, XP010923524 ISBN: 9781424401529
- JE-DEOK KIM ET AL: "Characteristics and high water-repellency of a-C:H films deposited by r.f. PECVD" SURFACE & COATINGS TECHNOLOGY ELSEVIER SWITZERLAND, vol. 162, no. 2-3, 20 janvier 2003 (2003-01-20), pages 135-139, XP002507033 ISSN: 0257-8972

## Description

L'invention concerne l'utilisation d'un film ou d'un revêtement à couche mince supraglissante pour améliorer l'aptitude à la lubrification d'une pièce destinée à être soumise à des frottements importants et à une usure importante.

Elle concerne également un procédé d'amélioration de l'aptitude à la lubrification d'une pièce destinée à être soumise à des frottements importants et à une usure importante.

Les phénomènes de frottement et d'usure dans les ensembles métalliques se rencontrent en particulier dans les dispositifs du type moteur, tels que des pistons, des segments, les arbres à came, mais aussi dans les domaines dans lesquels les frottements et la lubrification doivent être parfaitement maîtrisés, comme pour les vérins hydrauliques, les micromachines, les moules, les lames de rasoir, etc...

Ces phénomènes de frottement et d'usure sont à l'origine de pertes d'énergie considérables.

Un intérêt a donc été porté, depuis plusieurs années, sur l'étude du revêtement permettant de réduire ces phénomènes.

Les matériaux les plus utilisés actuellement en tant que revêtement et soumis à ces phénomènes sont les nitrures, tels que le nitrure de titane (TiN) et le nitrure de chrome (CrN), les carbures tels que le carbure de titane (TiC) et le carbure de chrome (CrC), le carbure de tungstène (W₂C), et les composites carbure de tungstène-carbone (WC/C), les oxydes tels que l'alumine, les dépôts à base de molybdène tels que le sulfure de molybdène (MoS₂), ainsi que toute la famille des revêtements à base de carbone appelés "Diamond Like Carbon" (DLC). Les DLC sont également appelés carbone amorphe hydrogéné (a:CH).

Ces derniers, de par leur combinaison exceptionnelle de propriétés, se sont révélés d'excellents candidats pour lutter contre ces phénomènes de frottement et d'usure.

Ils possèdent, en effet, à la fois des duretés élevées, de faibles coefficients de frottement et de faibles taux d'usure. C'est pourquoi les revêtements du type DLC sont largement utilisés dans le domaine mécanique afin d'améliorer la résistance à l'usure et de limiter les frottements entre différents composants mécaniques.

Par exemple, les sollicitations mécaniques et thermiques sur les pièces en frottement de l'attelage mobile d'un moteur à explosion sont extrêmement sévères.

Outre la composition du matériau de revêtement, un point important est également la lubrification des ces ensemble mécaniques qui doit être parfaitement optimisée afin de limiter les frottements entre les pièces et ainsi améliorer le rendement du moteur et de plus limiter l'usure de ces pièces.

Ce rôle de lubrification est donc primordial afin de limiter les émissions polluantes rejetées par un tel système.

De plus, le lubrifiant joue aussi le rôle de vecteur thermique en ayant une action contre les frottements et donc contre les échauffements locaux mais aussi en évacuant la chaleur engendrée par les frottements des différentes pièces. Les lubrifiants utilisés pour la lubrification de ces pièces sont généralement des lubrifiants à base d'une huile dont la viscosité peut varier.

Une des origines de l'usure sur ces pièces revêtues est, entre autre, un défaut de lubrification.

Dans ce contexte, l'invention vise à pallier le problème de la qualité de la lubrification de pièces soumises à des sollicitations mécaniques et thermiques fortes.

A cet effet, l'invention propose l'utilisation d'un film comprenant au moins :
- une couche en un matériau dur choisi parmi le nitrure de titane (TiN), le nitrure de chrome (CrN), le carbure de titane (TiC), le carbure de chrome (CrC), le carbure de tungstène (W₂C), et les composites carbure de tungstène-carbone (WC/C), l'alumine (Al₂O₃), le sulfure de molybdène (MoS₂), et les matériaux du type carbone amorphe hydrogéné (a : CH), comportant sur au moins une de ses faces une succession de cuvettes d'une profondeur comprise entre 30 nm et 2 µm, inclus, et de reliefs, d'une hauteur comprise entre 30 nm et 2 µm, inclus, et d'une largeur comprise entre 1 µm et 100 µm, inclus,
- une couche en un matériau oléophile, pour améliorer l'aptitude à la lubrification de pièces destinées à être soumises à une usure importante et à des frottements importants.

De préférence, la couche en un matériau dur est une couche en carbone amorphe hydrogéné.

Dans un mode de réalisation préféré, le film comprend de plus des nanoparticules et/ou des nanotubes déposés sur les parois internes des cuvettes de la couche.

Par ailleurs, de préférence, le matériau oléophile est un matériau à base de SiOx.

Plus préférablement, le matériau oléophile est un matériau à base de composé(s) organique(s) de silane(s) fluoré(s).

Egalement, de préférence, dans le mode de réalisation préféré de l'invention, les nanoparticules déposées sont choisies parmi des nanoparticules de métal, de silicium, de silice, de polymère et/ou de carbone et en ce que les nanotubes déposés sont des nanotubes de carbone.

Le revêtement est préférentiellement obtenu par les étapes suivantes :
a) dépôt sur au moins une surface d'une pièce destinée à être soumise à des frottements importants et à une usure importante d'une couche en un matériau dur choisi parmi le nitrure de titane (TiN), le nitrure de chrome (CrN), le carbure de titane (TiC), le carbure de chrome (CrC), le carbure de tungstène (W₂C), et les composites carbure de tungstène-carbone (WC/C), l'alumine (Al₂O₃), le sulfure de molybdène (MoS₂), et les matériaux du type carbone amorphe hydrogéné (a : CH),
b) création d'une succession de reliefs d'une hauteur comprise entre 30 nm et 2 µm, inclus, et d'une largeur comprise entre 1 µm et 100 µm, inclus, et de cuvettes ayant une profondeur comprise entre 30 nm et 2 µm, inclus, la couche obtenue à l'étape a) pour obtenir une couche texturée,
c) dépôt sur la couche obtenue à l'étape b) d'une couche en un matériau oléophile,
pour améliorer l'aptitude à la lubrification de ladite pièce.

De préférence, la couche texturée est une couche en carbone amorphe hydrogéné.

Dans un mode de réalisation préféré, le revêtement utilisé dans l'invention est obtenu par les étapes a), b) et c) et de plus, après l'étape b) et avant l'étape c), une étape b1) de dépôt de nanoparticules et/ou de nanotubes sur la couche texturée suivie d'une étape b2) de polissage de la surface supérieure de la couche obtenue à l'étape b1).

De préférence, le matériau oléophile est un matériau à base de SiOx.

Plus préférablement, le matériau oléophile est un matériau à base de composé(s) organique(s) de silane(s) fluoré(s).

Dans le cas où les nanoparticules sont déposées à l'étape b1), celles-ci sont choisies parmi des nanoparticules de métal, de silicium, de silice, de polymère et/ou de carbone et lorsque des nanotubes sont deposés à l'étape b1), il s'agit de nanotubes de carbone.

Il est également proposé un procédé pour améliorer l'aptitude à la lubrification d'une pièce destinée à être soumise à une usure importante et à des frottements importants comprenant les étapes suivantes :
a) dépôt, sur au moins une surface d'une pièce d'une couche en un matériau dur choisi parmi le nitrure de titane (TiN), le nitrure de chrome (CrN), le carbure de titane (TiC), le carbure de chrome (CrC), le carbure de tungstène (W₂C), et les composites carbure de tungstène-carbone (WC/C), l'alumine (Al₂O₃), le sulfure de molybdène (MoS₂), et les matériaux du type carbone amorphe hydrogéné (a : CH),
b) création d'une succession de reliefs et de cuvettes à la surface libre de la couche obtenue à l'étape a), pour obtenir une couche texturée,
c) dépôt d'une couche en un matériau oléophile sur la couche texturée obtenue à l'étape b).

De préférence, le matériau dur composant la couche déposée à l'étape a) est du carbone amorphe hydrogéné.

Dans un mode de mise en oeuvre préféré, le procédé de l'invention comprend de plus, après l'étape b) et avant l'étape c) une étape b1) de dépôt de nanoparticules et/ou de nanotubes sur la couche texturée obtenue à l'étape b) suivie d'une étape b2) de polissage de la surface supérieure de la couche obtenue à l'étape b1).

De préférence, dans les procédés de l'invention le matériau oléophile est un matériau à base de SiOx.

Plus préférablement, le matériau oléophile est un matériau à base de composé(s) organique(s) de silane(s) fluoré(s).

De préférence, lorsque les nanoparticules sont déposées à l'étape b1), elles sont choisies parmi des nanoparticules de métal, de silicium, de silice, de polymère et/ou de carbone et lorsque des nanotubes sont déposés à l'étape b1), ce sont des nanotubes de carbone.

L'invention sera mieux comprise et d'autres avantages et caractéristiques de celle-ci apparaitront plus clairement à la lecture de la description explicative qui suit et qui est faite en référence aux figures dans lesquelles :
- la figure 1 représente schématiquement chaque étape du mode de mise en oeuvre préféré du procédé de l'invention, c'est-à-dire de l'utilisation selon l'invention, et
- la figure 2 représente schématiquement un motif de texturation de la surface du matériau dur utilisé dans l'invention.

Les pièces soumises à des frottements et qui subissent une usure importante sont en général revêtues d'un matériau dur résistant lui-même aux frottements et à l'usure.

Ainsi, dans la présente invention, on désignera par les termes "matériau dur", les matériaux connus et généralement utilisés pour en particulier revêtir les pièces soumises à des frottements dont l'usure doit être diminuée. Ces matériaux durs sont actuellement les nitrures tels que le nitrure de titane(TiN) et le nitrure de chrome (CrN), les carbures tels que le carbure de titane (TiC) et le carbure de chrome (CrC), le carbure de tungstène (W₂C), et les composites carbure de tungstène-carbone (WC/C), les oxydes tels que l'alumine (Al₂O₃), les dépôts à base de molybdène tels que le sulfure de molybdène (MoS₂), ainsi que toute la famille des revêtements à base de carbone appelé "Diamond Like Carbon (DLC).

Les matériaux du type DLC sont également appelés carbone amorphe hydrogéné (a:CH). Ils possèdent à la fois des duretés élevées et de faibles coefficients de frottement et de taux d'usure. C'est pourquoi ils sont largement utilisés dans le domaine de la mécanique en tant que revêtement de pièces soumises à des frottements et à l'usure, afin d'améliorer leur résistance à l'usure et de limiter les frottements entre les différents composants mécaniques.

Ces revêtements constitués d'une couche mince, en particulier de type DLC, peuvent de plus être texturés en surface afin d'améliorer l'efficacité de lubrification des contacts entre pièces mécaniques.

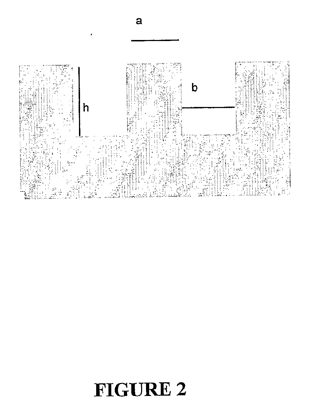

Les surfaces des revêtements sont dites texturées, lorsqu'elles comportent une suite de motifs définissant des creux et des reliefs, tels que représentés en figure 2, par exemple.

Il faut noter dès à présent que, bien qu'en figure 2 la forme des cuvettes formées soit du type rectangulaire, la morphologie des cuvettes ainsi que des reliefs n'est pas un paramètre de premier ordre, ce qui autorise la définition et la réalisation de géométries diverses et variées, comme des cônes, des cylindres ou des cubes.

Les paramètres importants du motif formé par la succession de cuvettes, également appelées ici, creux, et des reliefs sont au nombre de trois, indépendant de l'un de l'autre :
- le paramètre a définissant la largeur de chaque relief et qui peut varier entre 1 µm et 100 µm inclus,
- le paramètre h définissant la hauteur du relief, qui correspond donc à la profondeur de la cuvette, et qui peut varier entre 30 nm et 2 µm inclus, et
- le paramètre b, qui définit la largeur de la cuvette.

Ce paramètre b, peut varier le long de la hauteur ou profondeur h pour former d'autres motifs que ceux rectangulaires montrés en figure 2, par exemple pour former des cuvettes en forme de cône ou autre.

Dans l'invention, l'épaisseur de cette couche dure, est de préférence comprise entre 1 µm et 20 µm, inclus. Le plus préférablement, elle est de 5 µm.

Les épaisseurs citées ci-dessus sont celles de la couche dure déposée, avant sa texturation.

En effet, après texturation, la couche dure comprend des zones de moindres épaisseurs, correspondant aux microcuvettes.

Le fluide qui est à piéger est, dans le cas de l'invention, le lubrifiant utilisé pour limiter les frottements entre les pièces et limiter l'usure de ces pièces.

Les lubrifiants utilisés dans l'invention sont en général des lubrifiants à base d'huile.

Ainsi, dans l'invention, les termes "lubrifiantphile" signifient "oléophile" et sont utilisés de façon interchangeable.

Cependant, même avec une surface texturée et l'utilisation de lubrifiant, les pièces soumises à des frottements intenses telles que les pièces de l'attelage mobile d'un moteur à explosion s'usent très rapidement, principalement parce que la lubrification n'est souvent pas appliquée dans les zones géométriques voulues.

Ainsi, le but de l'invention est de fonctionnaliser le revêtement en un matériau dur, plus préférablement en carbone amorphe hydrogéné (dépôt tribologique), dans les zones sollicitées afin de rendre sa surface "attractive" pour le lubrifiant.

Pour cela, deux moyens sont mis en oeuvre.

Le premier consiste à texturer la surface du dépôt de la couche en matériau dur sur une portion de la surface de la pièce ou sur toute sa surface.

Cette étape consiste à créer des microréservoirs (les cuvettes) de taille, de répartition et de densité précises à la surface du revêtement en matériau dur.

Mais le coeur de l'invention est dans la combinaison du second moyen qui est associé au premier moyen décrit ci-dessus. Ce second moyen consiste à déposer un revêtement oléophile sur la surface texturée en matériau dur, y compris à l'intérieur des microréservoirs préalablement formés lors de la texturation de la surface du matériau dur.

Une telle architecture de revêtement est particulièrement intéressante pour une application tribologique. En effet, les couches oléophiles, par exemple les couches ou films polymères, déposées par exemple par PECVD (dépôt chimique en phase vapeur assistée par plasma), permettent de retenir le lubrifiant mais ne sont pas réputées pour leur résistance à l'usure abrasive contrairement au dépôt en un matériau dur tel qu'en un matériau de type DLC.

Cependant, on a constaté que de façon surprenante, en cours d'utilisation, en raison de la présence de la couche de surface oléophile, le lubrifiant va mouiller la surface entière ainsi revêtue, y compris les microréservoirs formés par la texturation mais, qu'en s'usant rapidement, c'est-à-dire dès le rodage des pièces, la couche oléophile va disparaître.

Dès lors, les frottements se feront sur la couche de matériau dur. Le lubrifiant sera donc forcé et attiré dans les microréservoirs, la couche en un matériau oléophile étant présente dans le fond de ces cavités.

L'épaisseur de la couche oléophile déposée est de préférence, dans l'invention, comprise entre 5 et 200 nm. Le plus préférablement elle est de 100 nm.

L'avantage par rapport à un revêtement en un matériau dur texturé seul est triple :
- premièrement, la lubrification est particulièrement efficace dans les zones sollicitées thermo-mécaniquement, là où les pressions de contact sont particulièrement élevées,
- deuxièmement, le fait de piéger le lubrifiant dans les microréservoirs formés lors de la texturation permet d'avoir une source de lubrifiant constante, même lors d'un changement de conditions de frottement, tel qu'un changement de vitesse de glissement des pièces, d'un changement de pression de contact, qui équivalent à des conditions de hertz, et
- troisièmement, les débris d'usure générés par l'usure abrasive importante lors de ce type de sollicitation sont piégés dans ces réservoirs et ainsi la formation d'un troisième corps dans la zone de frottement est limitée. En effet, ces débris sont souvent des particules dures qui forment des dépôts extrêmement durs et abrasifs contribuant à un endommagement sévère des pièces.

Autrement dit, l'avantage principal par rapport à un revêtement en un matériau dur texturé selon l'art antérieur est que l'on localise le lubrifiant et le piège à l'intérieur des microréservoirs formés par la texturation grâce au revêtement oléophile. Une simple texturation de surface serait beaucoup moins efficace en termes de lubrification lorsque les conditions de hertz sont variables comme c'est le cas pour un contact came/linguet, par exemple.

Le matériau utilisé pour former la couche oléophile peut être tout matériau adapté dans ce but. Les matériaux hydrocarbonés sont un exemple de matériau à affinité de mouillage avec des corps gras. Ceux-ci peuvent être déposés en couches minces par diverses méthodes telles que les méthodes sol-gel, les voies gazeuses. La technique de dépôt en phase vapeur d'un composé organométallique (MOCVD) est l'une des méthodes de dépôt qui peut être utilisée.

Concrètement, le matériau oléophile joue un rôle de rétention préférentielle du lubrifiant au sein des cuvettes obtenues par texturation. En pratique il est requis d'avoir un angle de contact inférieur à 90° et préférentiellement inférieur à 70° entre le matériau oleophile et le lubrifiant. Par exemple, des matériaux de type SiOx (silice sous-stoechiométrique) ont un angle de contact de l'ordre de 20° vis-à-vis d'une huile commerciale pour moteur, de même un matériau SiOC a un angle de contact de l'ordre de 40° vis-à-vis d'une huile commerciale pour moteur, démontrant par là leurs caractères oloéophiles.

En outre, le matériau oléophile pourra développer un caractère polaire qui favorisera son contact avec un lubrifiant polaire au contraire du DLC qui est non polaire.

Un exemple particulièrement préféré d'un matériau oléophile utilisé dans l'invention est un matériau organique du type silane, de préférence fluoré, comme par exemple le F(CF₂)n-CH₂CH₂Si(OH)₃. Un tel matériau est décrit dans WANG et al., "Stable highly hydrophobic and oleophilic meshes for oil-water séparation" Applied Surface Science 253 (2007) 9054-9060.

D'autres matériaux oléophiles sont envisageables, conformément aux connaissances de l'homme du métier dans ce domaine, comme par exemple les films téflonés (CF).

Selon un développement de l'invention, il est avantageux de prévoir une étape b1), avant l'étape c), consistant à réaliser un dépôt de nanoparticules et/ou de nanotubes dans le fond des cuvettes selon un principe de nanostructuration. Lesdites nanoparticules et/ou lesdits nanotubes peuvent être déposés par CVD et peuvent être composés d'un métal choisi parmi ceux des colonnes VIIIB et IB de la classification périodique des éléments ou d'un oxyde de ces métaux. D'autres nanoparticules envisageables sont des nanoparticules de silice, de polymère (polystyrène, polycarbonate), de silice et/ou de carbone. Les nanotubes envisageables sont les nanotubes de carbone.

Concrètement, la nanotexturation provenant du dépôt des nanoparticules et/ou des nanotubes va rendre les texturations particulièrement attractives pour les huiles et favoriser le mouillage vis-à-vis de ces huiles. En d'autres termes, cette nanotexturation fonctionne comme une éponge à huile.

Lorsqu'une étape b1) est mise en oeuvre dans le procédé de l'invention, avantageusement le dépôt de la couche oléophile effectué à l'étape c) ne recouvre pas complètement les nanoparticules et/ou les nanotubes de façon à induire un effet synergique des fonctions oléophiles de la couche (4) et de la nanotexturation favorisant le mouillage. Ainsi par exemple, le SiOC seul a un angle de contact de 40° pour l'huile qui passe à 20° si le SiOC est déposé sur des nanostructures.

Egalement selon les procédés de dépôt mis en jeu, l'étape b1) peut être ultérieure à l'étape c).

Afin de mieux faire comprendre l'invention, on va maintenant en décrire, à titre d'exemple purement illustratif et non limitatif, un mode de réalisation.

### Exemple 1 : Dépôt d'un revêtement selon l'invention

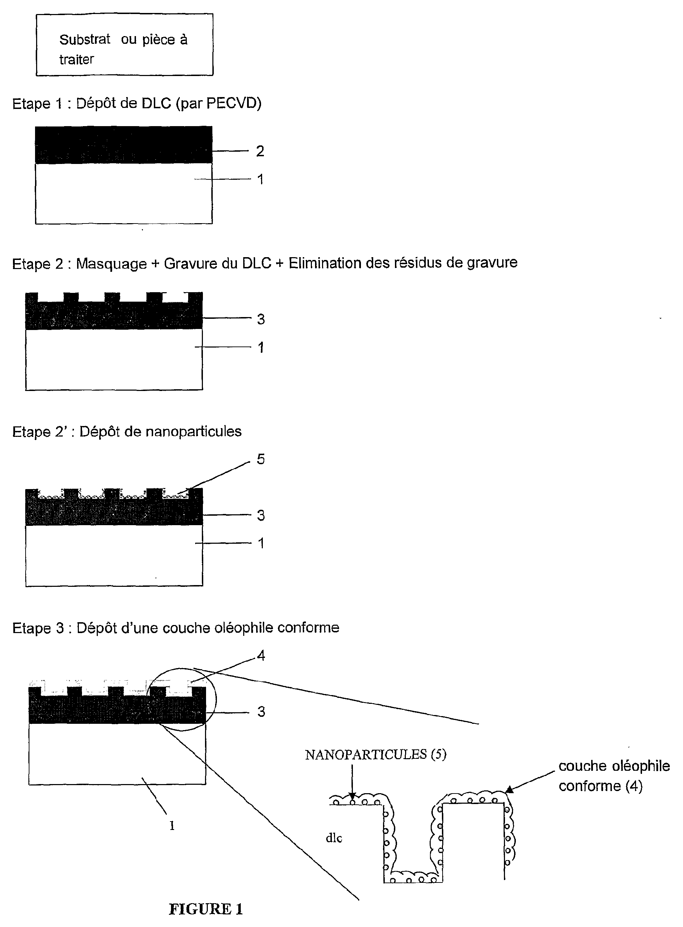

Les différentes étapes du procédé de dépôt d'un film utilisé dans l'invention sont schématiquement représentées en figure 1.

Tout d'abord, un substrat à traiter, c'est-à-dire la pièce destinée à être soumise à des frottements intenses et à une usure imoprtante à base d'acier, est nettoyé et préparé pour le dépôt.

Ce substrat est noté 1 en figure 1.

La première étape du procédé selon l'invention consiste alors à déposer une couche d'une épaisseur de 5 µm en un matériau dur, ici une couche de carbone amorphe hydrogéné, par dépôt chimique en phase vapeur (CVD). Ce dépôt peut être également déposé par dépôt physique en phase vapeur (PVD).

Les principales propriétés du revêtement en matériau dur sont de nature tribologique : dureté comprise entre environ 15 et environ 25 GPa, de préférence d'environ 20 GPa, coefficient de frottement en conditions lubrifiées face à un acier de type 100C6 inférieur à 0,1, et de préférence inférieur à 0,05. Le coefficient de frottement est mesuré en test tribologique pion disque. L'épaisseur du revêtement, qui est notée 2 en figure 1, est comprise entre 1 et 10µm, inclus, selon l'application.

L'étape 2 consiste ensuite à graver de façon anisotrope la couche 2 de type DLC avec des motifs élémentaires ayant des tailles, des rapports de forme et des taux d'ouverture tels que décrits précédemment, pour texturer la couche en matériau dur.

Cette texturation peut être obtenue, par exemple, par gravure sèche (gravure plasma) à l'aide d'un masque. Ce masque peut être réalisé par application directe d'un réseau, (par exemple grille métallique), par photolithographie (résine photo-sensible), par écriture directe au laser (résine photo-sensible). Après gravure, le masque est retiré manuellement ou par voie chimique, comme à l'aide d'un solvant pour une résine. Les résidus de gravure sont nettoyés par voie chimique, sèche et/ou humide.

On obtient alors la couche texturée notée 3 en figure 1.

Pour améliorer encore la texturation de la surface de la couche 3, une étape 2' notée en figure 1 peut être réalisée. Cette étape est optionnelle. Elle consiste en le dépôt de nanoparticules 5 sur la couche 3 texturée, ce dépôt étant suivant la forme de texturation de la couche 3.

Ces nanoparticules sont de préférence des nanoparticules ayant un diamètre compris entre 50 et 500 nm inclus, une forme aléatoire dépendante du mode de réalisation, mais principalement sphérique, en un métal tel que Ni, Ag, Al, ou encore en silicium.

La surface supérieure du dépôt de nanoparticules est ensuite polie pour retrouver la planéité sur la partie a des motifs de structuration.

Enfin, la troisième étape du procédé selon l'invention consiste à déposer sur la couche 3, ou sur la couche 5, une couche notée 4 en figure 1, en un matériau oléophile du type SiOx, d'une épaisseur de 100 µm.

La couche 4 en un matériau oléophile suit également la forme des motifs de texturation de la couche texturée 3.

Cette couche 4 peut être déposée par différents procédés, par exemple par dépôt en phase aqueuse ou sous vide. Cette couche doit avoir une énergie de surface suffisamment importante pour garantir le mouillage du fluide sur la couche 2. En pratique, on considère qu'une énergie de surface supérieure à 50mN/m permet de privilégier la localisation du lubrifiant au contact du matériau oléophile plutôt qu'au contact du DLC. Préférentiellement, une énergie de surface supérieure à 80mN/m sera recherchée.

On a ainsi obtenu un revêtement qui est utilisé dans l'invention pour améliorer l'aptitude à la lubrification d'une pièce destinée à être soumise à une usure importante et à des frottements intenses.

Le revêtement est un film comprenant une couche mince texturée 3 en un matériau dur, ici du carbone amorphe hydrogéné, cette couche 3 étant texturée et recouverte soit d'une couche 4 en un matériau oléophile, ici du SiOx, soit comprenant une couche mince 3 en un matériau dur, ici du carbone amorphe hydrogéné texturé, la couche 3 étant elle-même revêtue d'une couche de nanoparticules 5 qui est elle-même revêtue de la couche 4 en matériau oléophile.

Ce revêtement ou film de l'invention n'est pas limité aux seuls matériaux durs et matériaux composés de tous les matériaux durs et oléophiles cités dans la présente description, que ce soit ou non en combinaison avec des nanoparticules et/ou nanotubes décrits dans la présente description.

Ainsi, un autre revêtement ou film utilisé dans l'invention est un revêtement comprenant une couche mince texturée 3 en un matériau dur recouverte d'une couche 4 en matériau oléophile, cette couche 4 étant elle-même revêtue d'une couche de nanoparticules et/ou de nanotubes 5.

Encore, un autre revêtement utilisé dans l'invention est le revêtement après rodage de la pièce, c'est-à-dire un des revêtements comme décrits précédemment mais ne recouvrant pas toute la surface de la couche 3 ou de la couche 5, mais seulement les parois internes des creux formant la couche 3 ou la couche 5.

Ce revêtement peut être appliqué sur des vérins hydrauliques, des micromachines, des moules, des lames de rasoir, des pièces de moteur, des implants chirurgicaux, etc...

Ainsi, le revêtement utilisé dans l'invention, en le nommant revêtement, il apparaîtra clairement à l'homme de l'art que ce revêtement est constitué d'un film multi-couches dont une couche est la couche (3) et la seconde couche est la couche (4), et comprenant éventuellement des nanoparticules et/ou des nanotubes déposés sur les parois des cuvettes de la couche (3).

Ainsi, de la même façon, bien qu'à l'exemple 1 on ait décrit les étapes du procédé de dépôt d'un revêtement ou film utilisé dans l'invention, il apparaîtra clairement à l'homme de l'art que les différentes étapes de ce procédé sont également les différentes étapes du procédé d'amélioration de l'aptitude à la lubrification d'une pièce destinée à être soumise à une usure importante et à des frottements importants (intenses).

## Revendications

1. Utilisation d'un film comprenant au moins :
- une couche (3) en un matériau dur choisi parmi le nitrure de titane (TiN), le nitrure de chrome (CrN), le carbure de titane (TiC), le carbure de chrome (CrC), le carbure de tungstène (W₂C), et les composites carbure de tungstène-carbone (WC/C), l'alumine (Al₂O₃), le sulfure de molybdène (MoS₂), et les matériaux du type carbone amorphe hydrogéné (a :CH), la couche comportant sur une de ses faces une succession de cuvettes d'une profondeur comprise entre 30 nm et 2 µm, inclus, et de reliefs d'une hauteur comprise entre 30 nm et 2 µm, inclus, et d'une largeur comprise entre 1 µm et 100 µm, inclus,
- une couche (4) en un matériau oléophile,
pour améliorer l'aptitude à la lubrification de pièces.

2. Utilisation selon la revendication 1 **caractérisée en ce que** le matériau dur composant la couche (3) est du carbone amorphe hydrogéné.

3. Utilisation selon la revendication 1 ou 2 **caractérisée en ce que** le film comprend de plus des nanoparticules et/ou des nanotubes déposés sur les parois internes des micro-cuvettes de la couche (3).

4. Utilisation selon l'une quelconque des revendications précédentes **caractérisée en ce que** le matériau oléophile est un matériau à base de SiOx.

5. Utilisation selon l'une quelconque des revendications précédentes **caractérisée en ce que** le matériau oléophile est un matériau à base de composé(s) organique(s) de silane(s) fluoré(s).

6. Utilisation selon l'une quelconque des revendications 3 à 5 **caractérisée en ce que** les nanoparticules déposées sont choisies parmi des nanoparticules de métal, de silicium, de silice, de polymère et/ou de carbone et **en ce que** les nanotubes déposés sont des nanotubes de carbone.

7. Utilisation selon les revendications 1 à 6 **caractérisée en ce que** le film est obtenu par les étapes suivantes :
a) dépôt sur au moins une surface d'une pièce d'une couche (2) en un matériau dur choisi parmi le nitrure de titane (TiN), le nitrure de chrome (CrN), le carbure de titane (TiC), le carbure de chrome (CrC), le carbure de tungstène (W₂C), et les composites carbure de tungstène-carbone (WC/C), l'alumine (Al₂O₃), le sulfure de molybdène (MoS₂), et les matériaux du type carbone amorphe hydrogéné (a : CH),
b) création d'une succession de reliefs d'une hauteur comprise entre 30 nm et 2 µm, inclus, et d'une largeur comprise entre 1 µm et 100 µm, inclus, et de cuvettes ayant une profondeur comprise entre 30 nm et 2 µm, inclus, dans la couche (2) obtenue à l'étape a) pour obtenir une couche (3) texturée,
c) dépôt sur la couche (3) obtenue à l'étape b) d'une couche (4) en un matériau oléophile,
pour améliorer l'aptitude à la lubrification de ladite pièce.

8. Utilisation selon la revendication 7 **caractérisée en ce que** la couche texturée (3) est une couche en carbone amorphe hydrogéné.

9. Utilisation selon la revendication 7 ou 8 **caractérisée en ce qu'**elle comprend de plus, après l'étape b) et avant l'étape c) une étape b1) de dépôt de nanoparticules et/ou de nanotubes sur la couche texturée (3) suivie d'une étape b2) de polissage de la surface supérieure de la couche obtenue à l'étape b1).

10. Utilisation selon l'une quelconque des revendications 7 à 9 **caractérisée en ce que** le matériau oléophile composant la couche (4) est un matériau à base de SiOx.

11. Utilisation selon l'une quelconque des revendications 7 à 10 **caractérisée en ce que** le matériau oléophile composant la couche (4) est un matériau à base de composé(s) organique(s) de silane(s) fluoré(s).

12. Utilisation selon l'une quelconque des revendications 9 à 11 **caractérisée en ce que** les nanoparticules déposées à l'étape b1) sont choisies parmi des nanoparticules de métal, de silicium, de silice, de polymère et/ou de carbone et **en ce que** les nanotubes deposés à l'étape b1) sont des nanotubes de carbone.

## Patentansprüche

1. Verwendung eines Films, welcher mindestens Folgendes umfasst:
- eine Schicht (3) aus einem Hartmaterial, ausgewählt aus Titannitrid (TiN), Chromnitrid (CrN), Titancarbid (TiC), Chromcarbid (CrC), Wolframcarbid (W₂C), und Wolframkarbid-Kohlenstoff-Verbundmaterialien (WC/C), Aluminium (Al₂O₃), Molybdänsulfid (MoS₂), und Materialien des Typs amorpher hydrierter Kohlenstoff (a :CH), wobei die Schicht auf einer ihrer Flächen eine Folge an Vertiefungen einer Tiefe von zwischen einschließlich 30 nm und 2 µm, und an Erhebungen einer Höhe von zwischen einschließlich 30 nm und 2 µm, und einer Breite von zwischen einschließlich 1 µm und 100 µm aufweist,
- eine Schicht (4) aus einem oleophilen Material, um die Schmierfähigkeit von Teilen zu verbessern.

2. Verwendung nach Anspruch 1, **dadurch gekennzeichnet, dass** das Hartmaterial, aus dem die Schicht (3) besteht, amorpher hydrierter Kohlenstoff ist.

3. Verwendung nach Anspruch 1 oder 2, **dadurch gekennzeichnet, dass** der Film des Weiteren Nanopartikel und/oder Nanoröhrchen umfasst, welche an den Innenwänden der Mikrovertiefungen der Schicht (3) aufgebracht sind.

4. Verwendung nach einem der vorstehenden Ansprüche, **dadurch gekennzeichnet, dass** das oleophile Material ein Material auf Basis von SiOx ist.

5. Verwendung nach einem der vorstehenden Ansprüche, **dadurch gekennzeichnet, dass** das oleophile Material ein Material auf Basis von (einer) fluorierten organischen Silan-Verbindung(en) ist.

6. Verwendung nach einem der Ansprüche 3 bis 5, **dadurch gekennzeichnet, dass** die aufgebrachten Nanopartikel ausgewählt sind aus Metall-, Silicium-, Siliciumdioxid-, Polymer- und/oder Kohlenstoffnanopartikeln und dadurch, dass die aufgebrachten Nanoröhrchen Kohlenstoff-Nanoröhrchen sind.

7. Verwendung nach den Ansprüchen 1 bis 6, **dadurch gekennzeichnet, dass** der Film mittels der folgenden Schritte erhalten wird:
a) Aufbringen auf mindestens einer Fläche eines Teils einer Schicht (2) aus einem Hartmaterial, ausgewählt aus Titannitrid (TiN), Chromnitrid (CrN), Titancarbid (TiC), Chromcarbid (CrC), Wolframcarbid (W₂C), und Wolframkarbid-Kohlenstoff-Verbundmaterialien (WC/C), Aluminium (Al₂O₃), Molybdänsulfid (MoS₂), und Materialien des Typs amorpher hydrierter Kohlenstoff (a :CH),
b) Erzeugen einer Folge an Erhebungen einer Höhe von zwischen einschließlich 30 nm und 2 µm, und einer Breite von zwischen einschließlich 1 µm und 100 µm, und von Vertiefungen einer Tiefe von zwischen einschließlich 30 nm und 2 µm in der Schicht (2), die in Schritt a) erhalten wurde, um eine texturierte Schicht (3) zu erhalten,
c) Aufbringen auf der Schicht (3), welche in Schritt b) erhalten wurde, einer Schicht (4) aus einem oleophilen Material, um die Schmierfähigkeit des besagten Teils zu verbessern.

8. Verwendung nach Anspruch 7, **dadurch gekennzeichnet, dass** die texturierte Schicht (3) eine Schicht aus amorphem hydriertem Kohlenstoff ist.

9. Verwendung nach Anspruch 7 oder 8, **dadurch gekennzeichnet, dass** sie des Weiteren, nach Schritt b) und vor Schritt c) einen Schritt b1) des Aufbringens von Nanopartikeln und/oder Nanoröhrchen auf die texturierte Schicht (3), gefolgt von einem Schritt b2) des Polierens der Oberfläche der in Schritt b1) erhaltenen Schicht umfasst.

10. Verwendung nach einem der Ansprüche 7 bis 9, **dadurch gekennzeichnet, dass** das oleophile Material, aus welchem die Schicht (4) besteht, ein Material auf Basis von SiOx ist.

11. Verwendung nach einem der Ansprüche 7 bis 10, **dadurch gekennzeichnet, dass** das oleophile Material, aus welchem die Schicht (4) besteht, ein Material auf Basis von (einer) fluorierten organischen SilanVerbindung(en) ist.

12. Verwendung nach einem der Ansprüche 9 bis 11, **dadurch gekennzeichnet, dass** die in Schritt b1) aufgebrachten Nanopartikel ausgewählt sind aus Metall-, Silicium-, Siliciumdioxid-, Polymer- und/oder Kohlenstoffnanopartikeln und dadurch, dass die in Schritt b1) aufgebrachten Nanoröhrchen Kohlenstoff-Nanoröhrchen sind.

## Claims

1. Use of a film comprising at least:
- a layer (3) of a hard material selected from titanium nitride (TiN), chromium nitride (CrN), titanium carbide (TiC), chromium carbide (CrC), tungsten carbide (W₂C), and tungsten carbide-carbon composites (WC/C), alumina (Al₂O₃), molybdenum sulphide (MoS₂), and materials of the hydrogenated amorphous carbon type (a :CH), the layer including on one surface thereof a series of cavities with a depth between 30 nm and 2 µm, inclusive, and reliefs with a height between 30 nm and 2 µm, inclusive, and with a width between 1 µm and 100 µm, inclusive,
- a layer (4) of an oleophilic material, in order to improve the lubricity of parts.

2. Use according to claim 1 **characterised in that** the hard material comprising the layer (3) is hydrogenated amorphous carbon.

3. Use according to claim 1 or 2 **characterised in that** the film further comprises nanoparticles and/or nanotubes deposited on the inner walls of the micro-cavities of the layer (3).

4. Use as claimed in any preceding claim **characterised in that** the olephilic material is a material with a SiOx base.

5. Use as claimed in any preceding claim **characterised in that** the olephilic material is a material with a base of organic compounds(s) of fluorinated silane(s).

6. Use according to any of claims 3 to 5 **characterised in that** the deposited nanoparticles are selected from nanoparticles of metal, of silicon, of silica, of polymer and/or of carbon and **in that** the nanotubes deposited are carbon nanotubes.

7. Use according to claims 1 to 6 **characterised in that** the film is obtained by the following steps:
a) depositing on at least one surface of a piece of a layer (2) of a hard material selected from titanium nitride (TiN), chromium nitride (CrN), titanium carbide (TiC), chromium carbide (CrC), tungsten carbide (W₂C), and tungsten carbide-carbon composites WC/C), alumina (Al₂O₃), molybdenum sulphide (MoS₂), and materials of the hydrogenated amorphous carbon type (a :CH),
b) creating of a series of reliefs with a height between 30 nm and 2 µm, inclusive, and with a width between 1 µm and 100 µm, inclusive, and of cavities having a depth between 30 nm and 2 µm, inclusive, in the layer (2) obtained in the step a) in order to obtain a textured layer (3),
c) depositing on the layer (3) obtained in the step b) of a layer (4) of an oleophilic material,
in order to improve the lubricity of said part.

8. Use according to claim 7 **characterised in that** the textured layer (3) of the layer of hydrogenated amorphous carbon.

9. Use according to claim 7 or 8 **characterised in that** it further comprises, after the step b) and before the step c) a step b1) of depositing nanoparticles and/or nanotubes on the textured layer (3) followed by a step b2) of polishing of the upper surface of the layer obtained in the step b1).

10. Use according to any of claims 7 to 9 **characterised in that** the olephilic material comprising the layer (4) is a material with a SiOx base.

11. Use according to any of claims 7 to 10 **characterised in that** the olephilic material comprising the layer (4) is a material with a base of organic compounds(s) of fluorinated silane(s).

12. Use according to any of claims 9 to 11 **characterised in that** the nanoparticles deposited in the step b1) are selected from nanoparticles of metal, of silicon, of silica, of polymer and/or of carbon and **in that** the nanotubes deposited in the step b1) are carbon nanotubes.
